Europäisches Patentamt

European Patent Office

Office européen des brevets

(11) Publication number: **0 338 375**
**A1**

## EUROPEAN PATENT APPLICATION

(21) Application number: **89106326.5**

(22) Date of filing: **10.04.89**

(51) Int. Cl.4: **H01L 29/36**

(30) Priority: **11.04.88 JP 87379/88**

(43) Date of publication of application:
**25.10.89 Bulletin 89/43**

(84) Designated Contracting States:
**DE FR GB**

(71) Applicant: **HITACHI, LTD.**
**6, Kanda Surugadai 4-chome Chiyoda-ku**
**Tokyo(JP)**

(72) Inventor: **Matsui, Makoto**
**14-10, Kita-2-chome**
**Kunitachi-shi(JP)**
Inventor: **Yamaguchi, Ken**
**5-12, Maesawa-2-chome**
**Higashikurume-shi(JP)** .

(74) Representative: **Strehl, Schübel-Hopf,**
**Groening, Schulz**
**Maximilianstrasse 54 Postfach 22 14 55**
**D-8000 München 22(DE)**

(54) **Semiconductor material having periodic arrangement of impurities.**

(57) The present invention relates to a semiconductor material having a novel impurity arrangement, a semiconductor device using the same and a process for preparing the same. In the conventional semiconductor device impurity atoms are arranged at random, irrespective of diffusion or ion implantation, where the carrier mobility is lowered by the impurity and a high-speed operation is difficult to conduct.

In the present invention, impurity atoms are periodically arranged, where the carrier mobility is considerably enhanced, and an essentially high-speed operation of various semiconductor devices is attained.

FIG. 5

## SEMICONDUCTOR MATERIAL HAVING PERIODIC ARRANGEMENT OF IMPURITIES

### BACKGROUND OF THE INVENTION

This invention relates to a semiconductor device prepared from a semiconductor crystal having a novel arrangement of impurities and a process for preparing the semiconductor crystal, and particularly to a semiconductor device suitable for high-speed operation, a semiconductor crystal suitable for use in the semiconductor device and a process for preparing the same.

Recent progress of semiconductor device technique is remarkable, and improvement of the conventional type semiconductor device and development of semiconductor devices with novel structures are extensively made for the microfabrication and high-speed operation of semiconductor devices. The main part of a semiconductor device must be a n-type or p-type-doped region, irrespective of a conventional structure or a novel structure. In a conventional process for preparing a semiconductor device, doping of impurities is carried out by a diffusion method, an ion implantation method, etc. Doping of impurities during the crystal growth of semiconductor rods or during the vapor-phase epitaxial growth or solid-phase epitaxial growth is essentially doping of impurities according to a diffusion process.

A Schottky gate field-effect transistor is also called a metal-semiconductor (MES) field-effect transistor and is one example of the conventional semiconductor devices. It is well known that, for example, in an n-channel MES field-effect transistor the active layer through which carriers move is doped with n-type impurities approxiamtely at $1-2 \times 10^{17}$ cm$^{-3}$. Heretofore, the impurities-containing active layer has been formed by liquid-phase epitaxial growth or vapor-phase epitaxial growth.

A metal-oxide-semiconductor (MOS) field-effect transistor is another example of the conventional semiconductor devices. It is well known that in an n-channel MOS field-effect transistor the channel region is generally doped with a p-type impurity and the source region and the drain region are n$^+$ regions doped heavily with n-type impurities. On the other hand, in a p-channel MOS field-effect transistor the channel region is doped with an n-type impurity and the source region and the drain region are p$^+$ regions doped heavily with p-type impurities. Heretofore, these impurities-doped regions have been formed by a diffusion method or an ion implantation method. As literatures discloseing the distribution of impurities in the doping of impurities according to such kinds of technique, for example. J.M. Ziman: Models in Disorder, pp 106-107, Cambridge University Press (1979), etc. can be mentioned. As is obvious from Fig. 2.55 of the aforementioned literature, the impurities are distributed at random in the space of the region doped with impurities by the conventional technique.

### SUMMARY OF THE INVENTION

In the conventional semiconductor devices, the impurities are doped during the vapor-phase epitaxial growth or liquid-phase epitaxial growth or by a diffusion method or an ion implantation method. Thus, in the impurities-doped region of the conventional semiconductor devices, the impurities are distributed at random in the space. Therefore, the conventional semiconductor devices have a physical limit due to the randomness of the impurity distribution. For example, doping of the active layer of an n-channel MES field-effect transistor with n-type impurities approximately at $10^{17}$ cm$^{-3}$ is necessary for the formation of a necessary electron concentration for actuating the transistor. However, the electron mobility is considerably lowered by the influence of impurity scattering caused by the presence of n-type impurities. Thus, the conventional MES field-effect transistor has not a high field-effect mobility and thus has a limit to a high-speed operation.

Impurity of the channel region of a MOS field-effect transistor is necessary for the formation of a potential barrier for confining electrons or holes in the channel region or for the control of a transistor threshold gate voltage. However, the random distribution of many impurities in the channel region considerably lowers the carrier mobility, because the carriers are scattered by the impurities in the channel. Thus, the conventional MOS field-effect transistor has not a high field-effect mobility and thus has a limit to a high-speed operation.

These problems are encountered not only in the MOS field-effect transistor and a metal-semiconductor (MES) field-effect transistor, but also in a junction field-effect transistor, a bipolar transistor, etc., and thus are common problems in the semiconductor devices in general.

Generally, a higher transconductance $g_m$ in the semiconductor device means a higher speed operation and a lower power dissipation, and $g_m$ is proportional to a field-effect mobility, that is, an effective mobility of carriers through the channel region. That is, the formation of a channel in the semiconductor crystal layer having a high mobility is important for the high-speed operation of a semiconductor device.

The present invention can be attained by at least one of (1) a semiconductor single crystal which comprises a region in which individual donor atoms or individual acceptor atoms are periodically arranged at least in one direction, (2) a semiconductor device which comprises at least a semiconductlr single crystal, a pair of electrodes electrically connected each to predetermined parts of the single crystal and a carrier control means, where individual donor atoms or individual acceptor atoms are periodically arranged at least in the carrier-moving direction in the carrier-moving region of the semiconductor single crystal, and (3) a process for preparing a semiconductor single crystal, which comprises a first step of providing a semiconductor single crystal whose substrate cyrstal surface is inclined to the crystal plane and a second step of making at least one cycle of arranging donor atoms or acceptor atoms at a predetermined part of the semiconductor single crystal by molecular beam epitaxy and of growing the semiconductor single crystal epitaxially on the donor atoms or the acceptor atoms, thereby periodically arranging the donor atoms or the acceptor atoms in one direction.

The term "periodic arrangement" used herein means that the individual impurity (donor or acceptor) atoms are arranged periodically on an atomic level. Thus, the structure as is observed in the doping superlattice, that is, periodic formation of layers, where the distribution of individual impurity atoms is at random in a layer but the layer as a whole has a uniform impurity concentration, is different from the periodic arrangement as defined herein.

In the present invention, the periodic arrangement of donor atoms or acceptor atoms as impurity atoms is made at least in one direction. Let the direction be direction x. The impurity atoms can further take a periodic structure also in the directions y and z. When the impurity atoms are contained even in a very small amount, an effect is observable, but a concentration of roughly equal to, or higher than, $10^{15}$ cm$^{-3}$ is preferable. The upper limit to the concentration of impurity atoms depends upon a solubility limit to a semiconductor crystal and a concentration of less than about $10^{20}$ cm$^{-3}$ is preferable. The concentration of impurity atoms is controlled, for example, by an angle of the substrate crystal plane to the crystal plane during the crystal growth, as will be seen from Examples which follow. Crystal having a higher impurity concentration can be obtained with increasing angle. The angle is in a range of preferably 0.1 to 3 degrees, more preferably 0.5 to 3 degrees.

Furthermore, it is preferable that only the same species of impurity atoms, for example, only Sb, is arranged at least in one direction.

Phenomena of electrons in an ideal crystal free from impurities or defects can be interpreted according to the theory based on the one-body approximation that electrons move independently under an average periodic potential V(r) [ = V(r + T)] established by ion cores and other electrons. According to Bloch theorem, the wave function $\psi$(r) for an electron under the periodic potential V(r) is a plane wave exp (ik•r) modulated with a periodic function $u_k$(r) [ = $u_k$(r + T)] in case of free electron, that is,

$$\psi_k(r) = u_k(r) \exp(ik \cdot r)$$

Particularly when the periodic potential V(r) is negligibly lower compared to the electron energy, the wave function of electron has an energy eigenfunction only in a discontinuous energy band with a forbidden band due to the periodic potential, different from the free electron, and the wave function of electron can be approximated with the plane wave extended throughout the entire crystal, as in the case of free electron. In that case, the electronconduction can be discussed basically by way of motions of electrons present in the conduction band and holes present in the valence band. In that case, only if the concepts of the presence of "forbidden band" and "effective mass" are taken into account as influence factors of the periodic potential of the crystal, and the electrons and holes can be treated like free electrons, and scattering of electrons or holes by the potential of ion cores can be no more taken into account. The foregoing subjects are discussed in detail in C. Kittel: Introduction to Solid State Physics, 6th edition, John Wiley & Sons, Inc., New York, 1986, Chapters 7 to 8.

When the impurity atoms, for example, donors, are arranged in a specific direction in a periodic structure in a semiconductor crystal, the conduction electrons released from the donors move under the periodic potential formed by the ionized donors in the aforementioned direction, and this situation is similar to that of the previously mentioned electron under the periodic potential in the crystal. That is, the periodic structure formed by the donors corresponds to the crystal, the ionized donors to the ion cores and the conduction electrons to free electrons in a solid. That is, the donors arranged in a periodic structure form a "super crystal" and the conduction electrons released from the donors behave as electrons in the "super crystal", which move under the periodic potential formed by the "super crystal". The effect of scattering the electrons in the "super crystal", that is, conduction electrons, under the potential developed by the ionized donors is considerably reduced, as compared with the case where the donors are distributed at random, in the same manner that in the ordinary crystal the scattering of electrons within the crystal under the potential developed by the ion cores can be no more taken into account.

The main factors of a low conduction electron mobility in the semiconductor are usually the ionized impurity scattering and scattering by the lattice vibration (i.e. phonon scattering). Even if the donors are heavily doped, the effect of ionized impurity scattering is considerably small in the present case, and thus an n-type semiconductor crystal region having a high electron mobility similar to that at a very low impurity concentration can be obtained. It is needless to say that, even if the n-type semiconductor crystal region is used in a MOS field-effect transistor, etc. upon inversion to p-type, a high hole mobility can be obtained in the p-type inversion layer.

Furthermore, in the case where the acceptors are arranged in a specific direction in a periodic structure, a similar effect can be obtained, and thus a p-type semiconductor crystal region having a high hole mobility can be obtained. When the region is inverted to n-type, a high electron mobility can be obtained in the n-type inversion layer.

Thus, according to the present invention, an impurity-doped semiconductor region having a high electron (or hole) mobility can be formed, irrespective of n-type or p-type and irrespective of impurity concentration.

An object of the present invention is to provide a semiconductor single crystal where the carrier mobility is not lowered even when the semiconductor single crystal layer is doped with impurities, and a process for preparing the same.

Another object of the present invention is to provide a semiconductor device where the effective carrier mobility is not lowered in the channel region even when the main part of the semiconductor device is doped with impurities.

Other object of the present invention is to provide a semiconductor device capable of a high-speed operation.

These and other objects and many of the attendant advantages of this invention will be readily appreciated as the same becomes better understood by reference to the following detailed description when considered in connection with the accompanying drawings.

BRIEF DESCRIPTION OF THE DRAWINGS

Figs. 1, 5, 6 and 7 are schematic process step diagrams according to a first embodiment of the present invention.

Figs. 2A to 4B are schematic diagrams supplementarily showing the foregoing process step diagrams.

Fig. 8 is a cross-sectional view according to a second embodiment of the present invention.

DETAILED DESCRIPTION OF THE INVENTION

The present invention will be described in detail below, referring to Examples. For convenience of explanation, omission of indication and emphasis are made in the drawings (for example, omission of indication of matrix semiconductor atom, emphasis of kink part, etc.). Those skilled in the art can readily understand the omission of indication and emphasis. Parts indicated by the same reference numerals or symbols in the drawings show the same or equivalent parts throughout the drawings.

Example 1

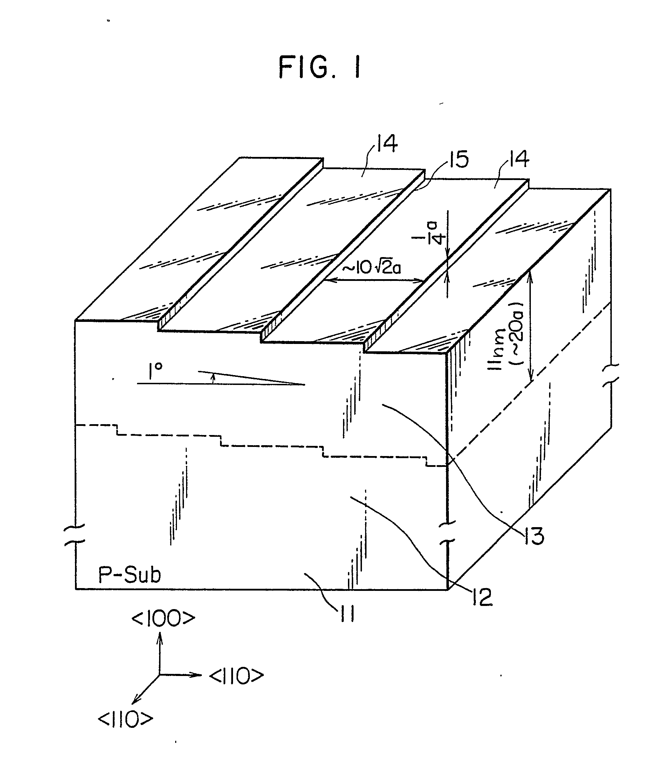

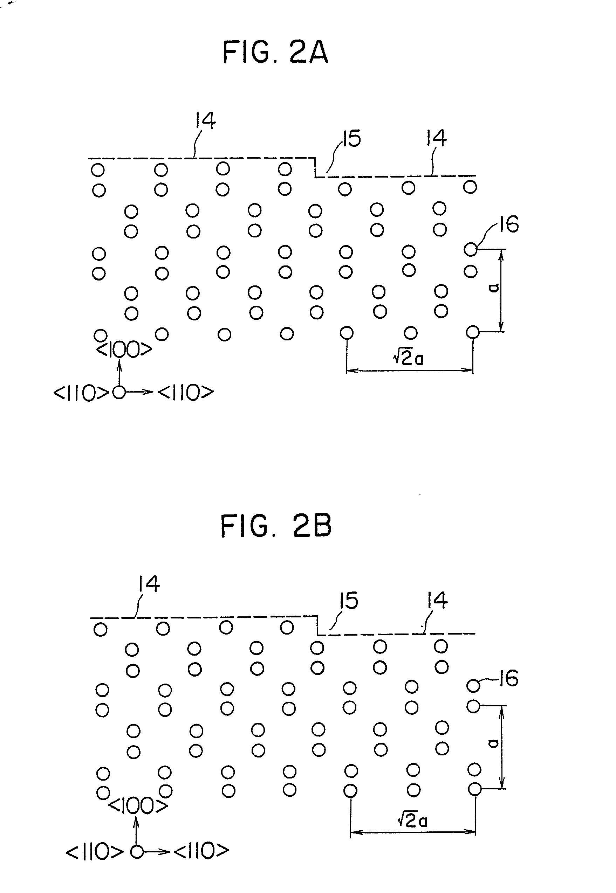

An embodiment of applying the present invention to a silicon (Si) single crystal layer doped heavily with donors will be explained, referring to process step diagrams of Figs. 1, 5, 6 and 7 and diagrams of Figs. 2A to 4B supplementing these process step diagrams, where silicon is used as a matrix semiconductor.

At first, reference is made to Fig. 1. As a substrate 11 a p-type Si single crystal wafer whose substrate surface was substantially in parallel to the (100) plane, whose resistivity was 6 $\Omega \cdot cm$ and whose surface was inclined by 1° from the (100) plane in the direction of <110> axis was used.

At first, the substrate surface was cleaned according to a method usually employed in the molecular beam epitaxy. Then, the substrate surface was exposed to simultaneous irradiation of Si beam and Ga beam at a substrate temperature of 750°C under ultra-high vacuum, whereby a p-type Si single crystal layer 12 with a thickness of 500 nm and a hole concentration of $5 \times 10^{15}$ $cm^{-3}$ was grown epitaxially. P-type impurity Ga is distributed at random in the layer. Then, the shutter for Ga was closed to make only irradiation of Si beam, whereby an undoped Si single crystal layer 13 having a thickness of 11 nm was formed. If the lattice constant is a ($= 0.543$ nm), the thickness corresponds substantially to 20a. It is well known that a flat, clean surface can be obtained by molecular beam epitaxy. It is also well known that, when the flat, clean surface is inclined to the crystal plane, stagewise steps due to the array of atoms appear. In the present case, steps shown in Fig. 1 and Figs. 2A and 2B seem to have appeared due to the Si crystal structure and the angle of inclination. Fig. 1 is a conceptual diagram of steps, where there are three stages of steps on the surface of undoped Si single crystal layer 13, and Figs. 2A and 2B schematically show the array of atoms near the steps. That is, Figs. 2A and 2B show that the steps have two structures. One step consists of a terrace 14 and a kink 15, and in the present case, a stage difference between one step and another is a monoatomic layer, i.e. 1/4 a and a step span is substantially 10 times √2 a, because the substrate surface is inclined by about one degree. Fig. 1 is a conceptual diagram explaining the steps and it is needless to say that an actual sample is sufficiently extended in two directions of <110> axis.

It is preferable that the step span is constant, but can involve a small error due to the fabrication technique.

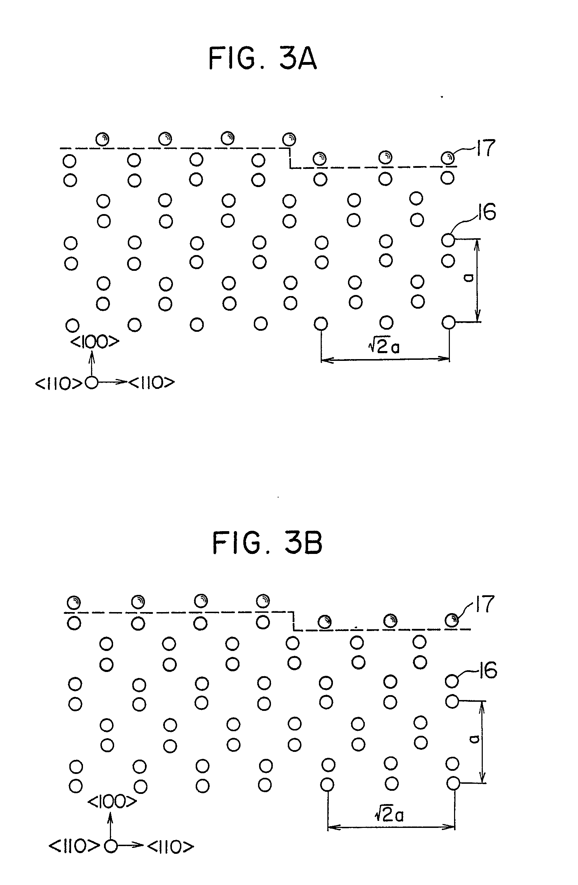

Then, the substrate temperature was lowered to 650°C and a shutter to a Sb-containing Knudsen cell kept at 450°C in advance was opened and the substrate surface was exposed to irradiation of at least a monoatomic layer of Sb beam, and then the shutter was closed. The bond energy between Sb and Si was high enough and the bond between Sb and Si was stable at 650°C, whereas the bond energy between Sb and Sb was relatively low and thus the bond between Sb and Sb was unstable at 650°C. That is, the Sb atoms bonded to the Si atoms on the surface of a sample existed stably, whereas the Sb atoms bonded only to the Sb atoms were vaporized again. Consequently, the layer of Sb atoms 17 was formed only in a monoatomic layer reflecting the Si crystal structure, as shown in Figs. 3A and 3B. Fig. 3A corresponds to Fig. 2A and Fig. 3B to Fig. 2A.

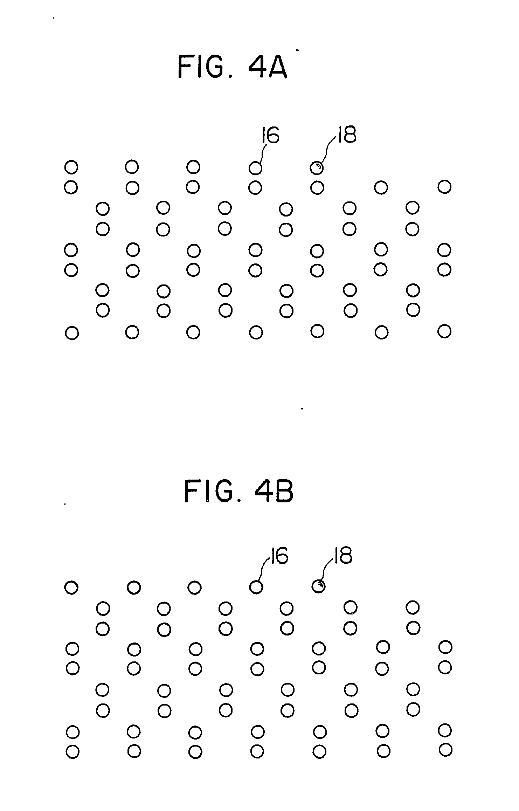

Then, the substrate temperature was elevated to 750°C and kept at 750°C for 300 seconds, and then the heater switch was turned off to rapidly lower the substrate temperature to less than 650°C. At 750°C the bond between Si and Sb turned unstable, and the Sb atoms on the surface of the sample were vaporized again and the number of Sb atoms was decreased with a time constant of 100 second. That is, the Sb atoms initially existing in the monoatomic layer was changed into a 0.05 atomic layer after 300 seconds, as shown in Figs. 4A and 4B. The 0.05 atomic layer corresponds to the number of the atom position 18 in a row at the original kink part. It is known that the crystal growth under ultra-high vacuum generally starts as a layer at the kink part, and the revaporization is deemed to proceed in the reversed course to the crystal growth. Thus, if the substrate temperature continues to be kept at 750°C, the Sb atoms at the position 18 lastly vaporize again but in the present case the Sb atoms will remain to the last, since the substrate temperature is kept at 750°C only for 300 secs. That is, in the present case the rows of Sb atoms 17 at a distance of

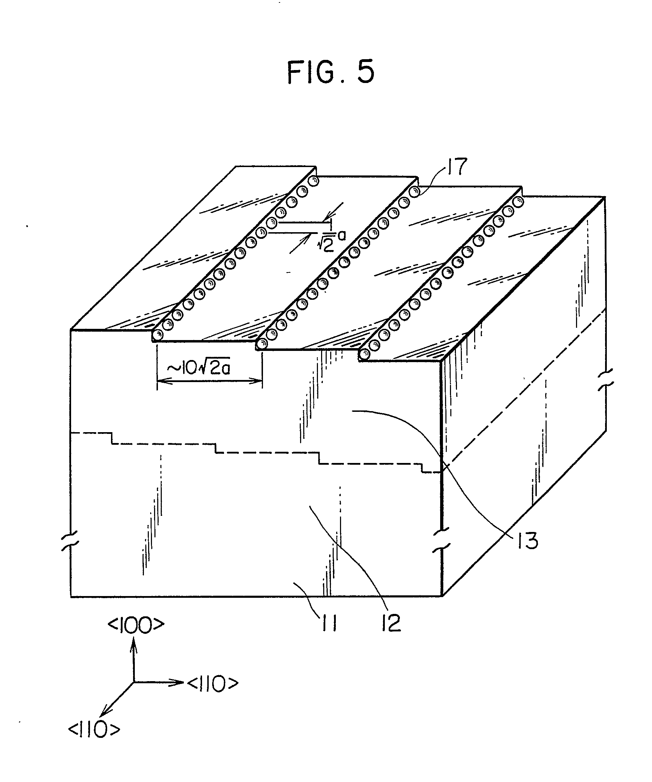

$$\frac{\sqrt{2}}{2} a$$ between one Sb atom and another in one row were arranged at a row distance of about 10 √2 a substantially in the direction of <110> axis, as shown in Fig. 5

A series of process steps from the exposure of the sample surface to irradiation of Sb beam to the aforementioned last operation will be hereinafter referred to as "formation of rows of Sb atoms" for a convenience.

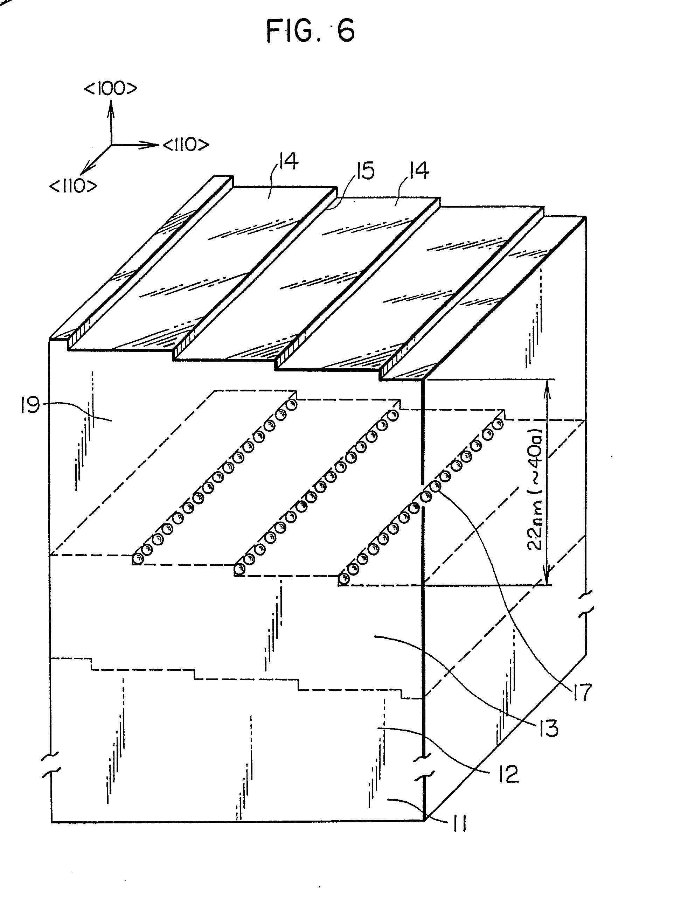

Then, the substrate surface was exposed to irradiation of Sb beam, while keeping the substrate temperature at 650°C to form an undoped Si single crystal layer 19 having a thickness of 22 nm (~40a), as shown in Fig. 6, where stagewise steps due to the array of atoms appeared. The step span was about 10 √2 a, but the kinks of the steps were not always right above the rows of Sb atoms previously formed.

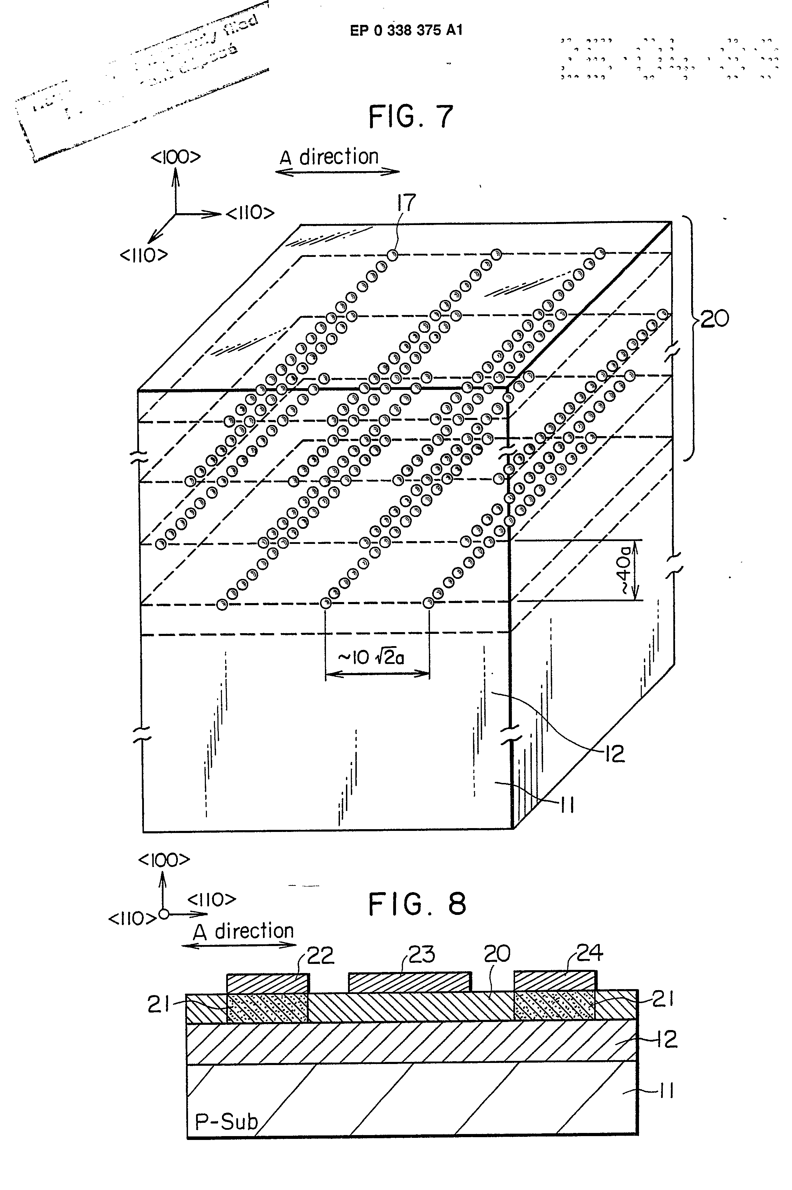

Then, formation of rows of Sb atoms and undoped Si single crystal growth to a thickness of 22 nm were alternately repeated 9 times, where the thickness of last undoped Si layer was made 11 nm, whereby an n-type Si layer 20 having a layer thickness of 220 nm and containing the impurity at a high concentration, where the donors were periodically distributed in the direction substantially in parallel to the direction A, that is, the <110> axis, was formed, as shown in Fig. 7.

Fig. 7 is a conceptual diagram explaining the arrangement of donors and it is needless to say that an actual sample is sufficiently extended in the two directions of <110> axis. The n-type Si layer 20 contains undoped Si layer 13, 19, etc. formed before, after, and between the formations of rows of Sb atoms.

By passing an electric current through the thus prepared n-type Si layer 20 in the direction A of Fig.7, a sheet carrier concentration (sheet electron concentration in the present case) and an electron mobility were determined and found to be $3.3 \times 10^{13}$ cm$^{-3}$ and 950 cm$^2$/V·s, respectively. By presuming the thickness of the n-type Si layer 20 to be 220 nm, the electron concentration was $1.5 \times 10^{19}$ cm$^{-3}$. Since the electron mobility of n-type Si layer containing $1.5 \times 10^{19}$ cm$^{-3}$ of donors, formed according to the conventional process was about 100 cm$^2$/V·s, the electron mobility of n-type Si layer containing an equal number of impurity was elevated to about 10 times as high according to the present invention. That is, a semiconductor crystal layer whose carrier mobility was not so much lowered as that of the intrinsic semiconductor even with increasing impurity concentration was obtained. A semiconductor crystal layer having such characteristics as explained above is useful for application to various semiconductor devices, particularly to semiconductor devices capable of high-speed operation.

In the foregoing embodiment a sample whose substrate surface was inclined by 1 degree from the (100) plane in the direction of <110> axis was used and thus the step span was about 10 $\sqrt{2}$ a, where a was a lattice constant. As already explained above, the angle of inclination is in a range of preferably 0.1 to 3 degrees, more preferably 0.5 to 3 degrees. Thus, the step span was approximately about $\frac{10}{3}$ $\sqrt{2}$ a to 100 $\sqrt{2}$ a or preferably $\frac{10}{3}$ $\sqrt{2}$ a to 20 $\sqrt{2}$ a .

This value is important in the actual process. That is, it is actually very difficult to grind a sample at a larger angle of inclination. In spite of these limitations it is possible to control the concentration of impurity atoms by controlling the thickness of an undoped layer 19 to be provided as an intermediate layer.

As shown in Fig. 7, the impurity atoms are continuously arranged in one direction, that is a kink direction, for example direction Y, when represented by a three-dimentional coordinate (X, Y and Z) in the matrix semiconductor, and periodically arranged in one direction (direction A) among the directions X and Z. With this arrangement, such a high mobility as explained above can be attained.

Example 2

The n-type Si layer 20 of Example 1, where the donors were periodically distributed in the direction substantially in parallel to the <110> axis, was applied to the active layer of an MES field-effect transistor. This embodiment of the present invention will be explained, referring to Fig. 8 showing a cross-sectional structural view of the embodiment.

In the same manner as in Example 1, a p-type Si single crystal layer 12 was made to grow epitaxially on a p-type Si substrate 11 and then an n-type Si layer, in which donors were periodically distributed in the direction (direction A) substantially in parallel to the <110> axis, was formed thereon. Then, n$^+$ conductive layers 21 were formed in a source region and a drain region by ion implantation and then a source electrode 22, a gate electrode 23 and a drain electrode 24 were formed by vacuum evaporation and selective etching to form an n-channel Si-MES field-effect transistor, as shown in Fig. 8. The gate length L was made 1 μm.

In spite of a high impurity concentration, that is, a high carrier concentration, the thus prepared Si-MES field-effect transistor had a high mobility. Hence, the transconductance $g_m$ per unit gate width was considerably increased, as compared with the conventional Si-MES field-effect transistor. The Si-MES field-effect transistor according to this embodiment was useful as a semiconductor device capable of high-speed operation.

In the foregoing Examples, Sb was used as an n-type impurity atom, and similar effects can be also obtained with P, As, etc. as an n-type impurity atom. Furthermore, Si was used as a matrix semiconductor in the foregoing Examples, and similar effects can be also obtained with Ge. Furthermore, similar effects can be also obtained with GaAs as a matrix semiconductor and Si, Ge, S, Sn, Te or Se as an n-type impurity atom.

In the foregoing Examples, n-type impurity atoms, that is, donors, were used as impurity atoms to be arranged in a periodic structure, and similar effects can be also obtained with p-type impurity atoms, that is, acceptors and holes as a carrier. In that case, when Si or Ge is used as a matrix semiconductor, it is appropriate to use B, Ga, In or Al as a p-type impurity atom, and when GaAs is used as a matrix semiconductor, it is appropriate to use Be, Mg, Zn, Cd or Mn as a p-type impurity atom.

An MES field-effect transistor was exemplified in Example 2 as an application example of a single crystal layer containing impurity atoms in a periodic structure to a semiconductor device, and similar effects can be also obtained with an MOS field-effect transistor, a junction field-effect transistor, a bipolar transistor, etc. Similar effects to those of Example 2 can be generally obtained when a single crystal layer containing impurity atoms in a periodic structure is used in a carrier-moving region in a semiconductor device comprising a pair of electrodes, a carrier-moving region sandwiched with the pair of electrodes and a carrier control means (for example, a gate in a field-effect transistor).

Particularly when the present invention is applied to an n-channel GaAs-MES field-effect transistor, a considerably higher speed operation can be obtained than that of the n-channel Si-MES field-effect transistor of Example 2, because the electron mobility of GaAs intrinsic semiconductor is about 6 times as high as that of Si.

As explained above, the carrier mobility within a semiconductor single crystal can be maintained higher according to the present invention even if the impurities are arranged in the semiconductor single crystal layer. Furthermore, a high-speed operation of a semiconductor device can be attained by using such a semiconductor single crystal layer as above as a channel region of semiconductor device.

It is further understood by those skilled in the art that the foregoing description is a preferred embodiment of the disclosed device and that various changes and modifications may be made in the invention without departing from the spirit and scope thereof.

Claims

1. A semiconductor material which comprises a matrix semiconductor in a single crystal and a plurality of donor atoms acting as donors or acceptor atoms acting as acceptors to the matrix semiconductor, wherein there is a region in which individual donor atoms or individual acceptor atoms of the plurality of donor atoms or acceptor atoms are periodically arranged at least in one direction.

2. A semiconductor material according to Claim 1, wherein the matrix semiconductor is Si or Ge and the donor atoms are Sb, P or As atoms.

3. A semiconductor material according to Claim 2, wherein the individual donor atoms or individual acceptor atoms are arranged at a distance of $\frac{10}{3}$ $\sqrt{2}$ a to 100 $\sqrt{2}$ a, preferably $\frac{10}{3}$ $\sqrt{2}$ a to 20 $\sqrt{2}$ a, wherein a is a lattice constant.

4. A semiconductor material according to Claim 2, wherein the individual donor atoms or individual acceptor atoms are continuously arranged in one direction Y, when represented by a three-dimensional coordinate X, Y and Z in the matrix semiconductor, and periodically arranged at least in one direction of other two directions X and Z.

5. A semiconductor material according to Claim 1, wherein the matrix semiconductor is Si or Ge and the acceptor atoms are B, Ga, In or Al atoms.

6. A semiconductor material according to Claim 1, wherein the matrix semiconductor is GaAs and the donor atoms are Si, Ge, S, Sn, Te or Se atoms.

7. A semiconductor material according to Claim 4, wherein the matrix semiconductor is GaAs and the acceptor atoms are Be, Mg, Zn, Cd or Mn atoms.

8. A semiconductor device which comprises at least one semiconductor single crystal, a pair of electrodes electrically connected each to predetermined parts of the single crystal and a carrier control means, wherein individual donor atoms or individual acceptor atoms are periodically arranged at least in a carrier-moving direction in a carrier-moving region of the semiconductor single crystal.

9. A process for preparing a semiconductor single crystal, which comprises a first step of providing a semiconductor single crystal whose substrate crystal surface is inclined to the crystal plane and a second step of making at least one repetition of arranging donor atoms or acceptor atoms at a predetermined part of the semiconductor single crystal by molecular beam epitaxy and of making the semiconductor single crystal grow epitaxially on the donor atoms or the acceptor atoms, thereby periodically arranging the donor atoms or the acceptor atoms in one direction.

10. The invention of Claim 8 or 9, wherein the matrix semiconductor of the semiconductor single crystal is Si or Ge and the donor atoms are Sb, P or As atoms.

11. The invention of Claim 8 or 9, wherein the matrix semiconductor of the semiconductor single crystal is Si or Ge and the acceptor atoms are B, Ga, In or Al atoms.

12. The invention of Claim 8 or 9, wherein the matrix semiconductor of the semiconductor single crystal is GaAs and the donor atoms are Si, Ge, S, Sn, Te or Se atoms.

13. The invention of Claim 8 or 9, wherein the matrix semiconductor of the semiconductor single crystal is GaAs and the acceptor atoms are Be, Mg, Zn, Cd or Mn atoms.

14. A process according to Claim 9, wherein the substrate crystal surface is inclined at 0.1 to 3°, preferably 0.5 to 3°.

# FIG. I

## FIG. 2A

## FIG. 2B

# FIG. 3A

# FIG. 3B

# FIG. 4A

16    18

# FIG. 4B

16    18

# FIG. 5

$\frac{1}{\sqrt{2}}a$

$\sim 10\sqrt{2}a$

17

13

11

12

<100>

<110>

<110>

# FIG. 6

# FIG. 7

# FIG. 8

## DOCUMENTS CONSIDERED TO BE RELEVANT

| Category | Citation of document with indication, where appropriate, of relevant passages | Relevant to claim | CLASSIFICATION OF THE APPLICATION (Int. Cl. 4) |
|---|---|---|---|
| X | IBM TECHNICAL DISCLOSURE BULLETIN vol. 29, no. 6, November 1986, pages 2581-2583, New York, USA; "MISFIT Dislocation Superlattice Production" * page 2581, paragraph 1; figures * | 1,2,4,5 ,8,10, 11 | H 01 L 29/36 H 01 L 21/203 |
| A | idem | 3,9 | |
| X | APPLIED PHYSICS LETTERS vol. 49, no. 25, December 1986, pages 1729-1731, New York, USA; E. F. SCHUBERT et al.: "Self-aligned enhancement-mode and depletion-mode GaAs field-effect transistors employing the delta-doping technique" * figure 1; page 1729 * | 1,4,6-8 ,12,13 | |
| A | idem | 3,9 | |

TECHNICAL FIELDS
SEARCHED (Int. Cl.4)

H 01 L 29/00
H 01 L 21/00

The present search report has been drawn up for all claims

| Place of search | Date of completion of the search | Examiner |
|---|---|---|
| BERLIN | 24-07-1989 | JUHL A. |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons.
........................................................................
& : member of the same patent family, corresponding
    document

EPO FORM 1503 03.82 (P0401)